(19) **Europäisches Patentamt / European Patent Office / Office européen des brevets**

(11) **EP 4 726 403 A1**

(12) **EUROPEAN PATENT APPLICATION**
published in accordance with Art. 153(4) EPC

(43) Date of publication:
15.04.2026 Bulletin 2026/16

(21) Application number: 24830087.3

(22) Date of filing: 16.04.2024

(51) International Patent Classification (IPC):
*G01R 31/317* (2006.01)

(52) Cooperative Patent Classification (CPC):
G01R 31/317; G01R 31/3185; G01R 31/319

(86) International application number:
PCT/CN2024/088056

(87) International publication number:
WO 2025/001438 (02.01.2025 Gazette 2025/01)

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH MA MD TN

(30) Priority: 30.06.2023 CN 202310804578

(71) Applicant: Sanechips Technology Co., Ltd.
Shenzhen, Guangdong 518055 (CN)

(72) Inventors:
• PENG, Minqiang
  Shenzhen, Guangdong 518055 (CN)
• CHENG, Qi
  Shenzhen, Guangdong 518055 (CN)
• CHEN, Xiwu
  Shenzhen, Guangdong 518055 (CN)
• HUANG, Xiaobin
  Shenzhen, Guangdong 518055 (CN)

(74) Representative: Cristinelli, Luca et al
Jacobacci & Partners S.p.A.
Corso Emilia, 8
10152 Torino (IT)

(54) **CHIP AND ELECTRONIC DEVICE**

(57) Provided in the embodiments of the present disclosure are a chip and an electronic device. The chip includes: a plurality of chip ports, a port multiplexing logic module and a scan test logic module, wherein the port multiplexing logic module is provided with a plurality of groups of first ports and a plurality of groups of second ports, and the plurality of chip ports are divided into a plurality of groups according to a preset granularity; each group of chip ports is connected to at least one of the plurality of groups of first ports and the plurality of groups of second ports of the port multiplexing logic module, and the plurality of groups of first ports or the plurality of groups of second ports of the port multiplexing logic module are connected to the scan test logic module; and the port multiplexing logic module is configured to control the gating of a path between each of the chip ports and the scan test logic module according to a control instruction and in the unit of the preset granularity.

```
┌──────────────┐
│ chip port 12 │───┐
└──────────────┘   │
                   │    ┌──────────┐   ┌─────────┐
┌──────────────┐   ├────│  port    │───│  scan   │
│ chip port 12 │───┤    │ multipl- │   │  test   │
└──────────────┘   │    │ exing    │   │ logic   │
                   │    │ logic    │   │ module  │
      ......       │    │ module   │   │  16     │
                   │    │  14      │   └─────────┘
┌──────────────┐   │    └──────────┘
│ chip port 12 │───┘
└──────────────┘
```

Fig. 1

EP 4 726 403 A1

## Description

### Cross-Reference to Related Application

The present disclosure claims the priority of Chinese Patent Application NO.202310804578.1, filed on June 30, 2023 and entitled "CHIP AND ELECTRONIC DEVICE", the disclosure of which is incorporated herein by reference in its entirety.

### Technical Field

The present disclosure relates to the field of chip design, and in particular, to a chip and an electronic device.

### Background

With the continuous increase of the complexity of integrated circuits, in order to effectively screen out faults of chips and reduce test time, a scan chain test technology plays an important role. With the continuous development of the scale of integrated circuits, in order to avoid overly long scan chains that are detrimental to testing, Embedded Deterministic Testing (EDT) compression technology is introduced to increase the number of scan chains and reduce the length of each scan chain. The number of scan chains continues to increase, while the chip's Input/Output (I/O) resources are relatively limited, so time-division multiplexing of I/O resources is required.

Currently, a pin multiplexing (PinMux) method commonly used in the industry is to group different modules and allocate fixed I/O resources to the modules. However, in the early phases of chip design, it is difficult to accurately determine the complexity of each module and the power consumption distribution. The optimal grouping strategy can only be determined after sign-off or even after tape-out. The traditional grouping method has fixed I/O allocation, and design adjustment cannot be made according to the optimal grouping, which may easily lead to unreasonable I/O allocation. As a result, complex modules do not obtain a sufficient number of I/O resources, resulting in long test time, uneven power consumption distribution, and device voltage drop and other problems.

In summary, there is no good solution to the problems of unreasonable I/O allocation and long test time of large-scale complex chips in the related art.

### Summary

Embodiments of the present disclosure provide a chip and an electronic device, so as to at least solve the problems of unreasonable I/O allocation and long test time of large-scale complex chips in the related art.

According to an embodiment of the present disclosure, a chip is provided. The chip includes a plurality of chip ports, a port multiplexing logic module and a scan test logic module, wherein the port multiplexing logic module has a plurality of groups of first ports and a plurality of groups of second ports, and the plurality of chip ports are divided into a plurality of groups according to a preset granularity; each group of chip ports is connected to at least one group of the plurality of groups of first ports and the plurality of groups of second ports of the port multiplexing logic module; and the plurality of groups of first ports or the plurality of groups of second ports of the port multiplexing logic module are connected to the scan test logic module; and the port multiplexing logic module is configured to control path gating between the chip ports and the scan test logic module at a preset granularity according to a control instruction.

According to another embodiment of the present disclosure, an electronic device is further provided, including the chip according to any one of the above embodiments.

### Brief Description of the Drawings

Fig. 1 is a structural block diagram of a chip according to an embodiment of the present disclosure;

Fig. 2 is a structural block diagram of another chip according to an embodiment of the present disclosure;

Fig. 3 is a schematic circuit structure diagram of a chip according to an embodiment of the present disclosure;

Fig. 4 is a schematic circuit structure diagram (I) of a port multiplexing logic module according to an embodiment of the present disclosure;

Fig. 5 is a schematic circuit structure diagram (II) of a port multiplexing logic module according to an embodiment of the present disclosure;

Fig. 6 is a schematic circuit structure diagram (III) of a port multiplexing logic module according to an embodiment of the present disclosure;

Fig. 7 is a schematic circuit structure diagram (IV) of a port multiplexing logic module according to an embodiment of the present disclosure.

**Detailed Description of the Embodiments**

The embodiments of the present disclosure are described in detail with reference to the accompanying drawings and in conjunction with the embodiments.

It should be noted that the terms "first", "second" etc. in the description, claims, and accompanying drawings of the present disclosure are used to distinguish similar objects, and are not necessarily used to describe a specific sequence or order.

Embodiments of the present disclosure provide a chip, applied to embedded deterministic testing. With the continuous development of chip scale, the number of scan chains to be tested is also increasing. However, the I/O resources of the chip are relatively limited. A chip to be tested designed according to the following embodiments can readjust, the connection relationship between chip ports and scan chains to be tested inside the chip during the chip testing phase, so as to realize dynamic adjustment and flexible allocation of I/O resources.

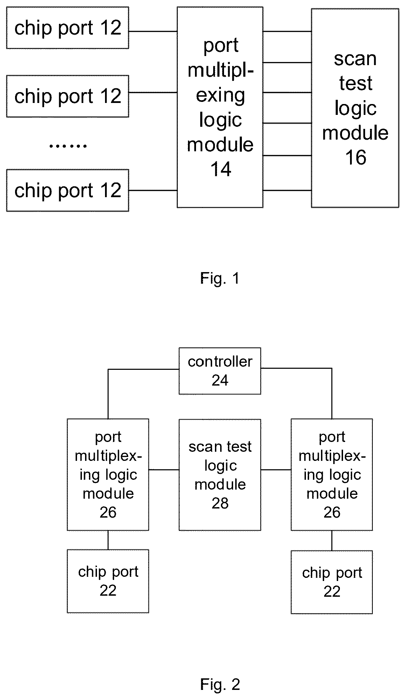

Fig. 1 is a structural block diagram of a chip according to an embodiment of the present disclosure. As shown in Fig. 1, the chip includes the following structure:

a plurality of chip ports 12, a port multiplexing logic module 14, and a scan test logic module 16.

In the present embodiment, the port multiplexing logic module has a plurality of groups of first ports and a plurality of groups of second ports, and the plurality of chip ports are divided into a plurality of groups according to a preset granularity.

In the present embodiment, each group of chip ports is connected to at least one group of the plurality of groups of first ports and the plurality of groups of second ports of the port multiplexing logic module; and the plurality of groups of first ports or the plurality of groups of second ports of the port multiplexing logic module are connected to the scan test logic module.

In the present embodiment, the port multiplexing logic module is configured to control path gating between the chip ports and the scan test logic module at a preset granularity according to a control instruction.

Through the embodiments of the present disclosure, port grouping can be realized through the preset granularity, thereby improving the degree of freedom of I/O allocation. The electrical connection relationship between input ports and output ports is controlled in units of granularity, so as to at least solve problems of unreasonable I/O allocation and long test time in large-scale complex chips in the related art. I/O resources can also be dynamically adjusted during the testing phase, which effectively reduces the chip test time.

In some embodiments, the plurality of chip ports are divided into i+1 groups, and the number of port groups of the scan test logic module is j+1, i being less than j, and i and j being positive integers. in a case where the chip ports are chip input ports, where the plurality of groups of first ports of the port multiplexing logic module are a plurality of groups of input ports, and where the plurality of groups of second ports of the port multiplexing logic module are a plurality of groups of output ports, each group of chip ports is connected to at least one group of the plurality of groups of first ports of the port multiplexing logic module, the plurality of groups of second ports of the port multiplexing logic module are connected to the scan test logic module, the number of input port groups of the port multiplexing logic module is i+1, and the number of output port groups of the port multiplexing logic module is j+1.

In some embodiments, the port multiplexing logic module includes j+1 first multiplexer groups, wherein each of the first multiplexer groups is connected to i+1 input port groups of the port multiplexing logic module, and each of the first multiplexer groups is connected to one output port group of the port multiplexing logic module; each of the first multiplexer groups is configured to gate one target input port group among the i+1 input port groups and a corresponding target output port group according to the control instruction.

In some embodiments, in a case where the preset granularity is N, each of the input port groups includes N input ports, each of the output port groups includes N output ports, and each of the first multiplexer groups includes N first multiplexers.

In some embodiments, the port multiplexing logic module further includes i+1 input register groups and j+1 input channel register groups; the i+1 input port groups are connected to each of the first multiplexer groups through the i+1 input register groups; each of the first multiplexer groups is connected to one output port group through one input channel register group.

In some embodiments, the port multiplexing logic module includes i+1 first demultiplexer groups and j+1 OR operation modules, wherein each of the first demultiplexer groups is connected to an input port group of the port multiplexing logic module, each of the first demultiplexer groups is connected to the j+1 OR operation modules, and each of the OR operation modules is connected to one output port group of the port multiplexing logic module; first demultiplexer group is configured to gate one target output port group among the j+1 output port groups and a corresponding target input port group according to the control instruction.

In some embodiments, in a case where the preset granularity is N, each of the input port groups includes N input ports, each of the output port groups includes N output ports, and each of the first demultiplexer groups includes N first demultiplexers.

In some embodiments, the port multiplexing logic module further includes i+1 input register groups and j+1 input channel register groups; each of the input port groups is connected to one first demultiplexer group through one input register group; each of the OR operation modules is connected to one output port group through one input channel register group.

In some embodiments, the plurality of chip ports are divided into i+1 groups, and the number of the port groups of the scan test logic module is j+1, i being less than j, and i and j being positive integers. in a case where the chip port is a chip output port, where the plurality of groups of second ports of the port multiplexing logic module are a plurality of groups of output ports, and where the plurality of groups of first ports of the port multiplexing logic module are a plurality of groups of input ports, each group of chip ports is connected to at least one group of the plurality of groups of second ports of the port multiplexing logic module, the plurality of groups of first ports of the port multiplexing logic module are connected to the scan test logic module, the number of input port groups of the port multiplexing logic module is j+1, and the number of output port groups of the port multiplexing logic module is i+1.

In some embodiments, the port multiplexing logic module includes i+1 second multiplexer groups, wherein each of the second multiplexer groups is connected to j+1 input port groups of the port multiplexing logic module, and each of the second multiplexer groups is connected to one output port group of the port multiplexing logic module; second multiplexer group is configured to gate one target input port group among the j+1 input port groups and a corresponding target output port group according to the control instruction.

In some embodiments, in a case where the preset granularity is N, each of the input port groups includes N input ports, each of the output port groups includes N output ports, and each of the second multiplexer groups includes N second multiplexers.

In some embodiments, the port multiplexing logic module further includes j+1 output channel register groups and i+1 output register groups; each input port group is connected to each of the second multiplexer groups through one output channel register group, and each of the second multiplexer groups is connected to one output port group through one output register group.

In some embodiments, the port multiplexing logic module includes j+1 second demultiplexer groups and i+1 OR operation modules, wherein each of the second demultiplexer groups is connected to one input port group of the port multiplexing logic module, each of the second demultiplexer groups is connected to the i+1 OR operation modules, and each of the OR operation modules is connected to one output port group of the port multiplexing logic module; second demultiplexer group is configured to gate one target output port group among i+1 output port groups and a corresponding target input port group according to the control instruction.

In some embodiments, in a case where the preset granularity is N, each of the input port groups includes N input ports, each of the output port groups includes N output ports, and each of the second demultiplexer groups includes N second demultiplexers.

In some embodiments, the port multiplexing logic module further includes j+1 output channel register groups and i+1 output register groups; each input port group is connected to one second demultiplexer group through one output channel register group; each of the OR operation modules is connected to one output port group through one output register group.

An embodiment of the present disclosure further provides a test chip.

Fig. 2 is a structural block diagram of another chip according to an embodiment of the present disclosure. As shown in Fig. 2, the chip includes:

chip port(s) 22, a controller 24, port multiplexing logic module(s) 26, and a scan test logic module 28.

In the present embodiment, the chip ports are connected to ports of the scan test logic module through the port multiplexing logic module, wherein the number of the chip ports is less than the number of the ports of the scan test logic module.

In the present embodiment, the controller is configured to send a control instruction to the port multiplexing logic module.

In the present embodiment, the port multiplexing logic module is the port multiplexing logic module of any one of the foregoing embodiments, which may be a port multiplexing logic module and/or a port multiplexing logic module.

In the present embodiment, the scan test logic module includes a plurality of embedded deterministic testing

(EDT) channel chains, wherein the ports of the scan test logic module are ports of the EDT channel chains.

Further, the scan test logic module is configured to test the EDT channel chains conductively connected to the chip ports.

In some embodiments, the scan test logic module includes a plurality of scan test modules, wherein each of the scan test modules includes at least one EDT channel chain; the scan test logic module is configured to respectively test each test group of the plurality of test groups at different time, wherein each test group includes at least one EDT channel chain group, the plurality of EDT channel chains are divided into a plurality of **EDT** channel chain groups according to the preset granularity, and the plurality of test groups are allocated according to attribute parameters of the plurality of scan test modules.

Through the embodiments of the present disclosure, test grouping can be dynamically adjusted according to attribute parameters of test modules during the chip testing phase, which effectively reduces the test time, thereby solving the problems of unreasonable I/O allocation and long test time of large-scale complex chips in the related art.

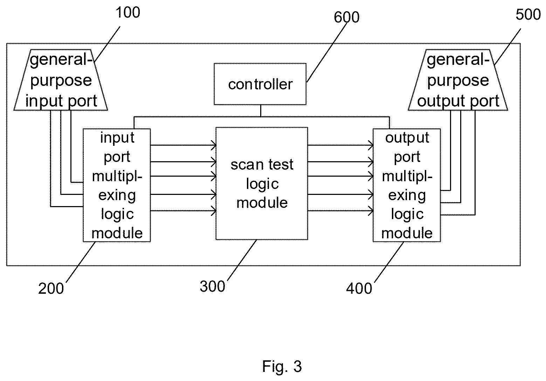

Fig. 3 is a schematic circuit structure diagram of a chip according to an embodiment of the present disclosure. As shown in Fig. 3, the chip includes the following structure:

a plurality of general-purpose input ports 100, a port multiplexing logic module 200, a scan test logic module 300, a port multiplexing logic module 400, a plurality of general-purpose output ports 500, and a controller 600.

In the present embodiment, the plurality of general-purpose input ports 100 are equivalent to the chip input ports in the foregoing embodiments, and the plurality of general-purpose output ports 500 are equivalent to the chip output ports in the foregoing embodiments.

In the present embodiment, the plurality of general-purpose input ports and the plurality of general-purpose output ports are divided into a plurality of I/O groups according to a preset granularity.

Further, data is input to the port multiplexing logic module from the general-purpose input ports in general-purpose input/output (GPIO); and after passing through the scan test logic module, a data result obtained by testing is output from the general-purpose output ports.

In the present embodiment, the plurality of general-purpose input ports are connected to a plurality of input ports of the port multiplexing logic module; a plurality of output ports of the port multiplexing logic module are connected to a plurality of input ports of the scan test logic module; a plurality of output ports of the scan test logic module are connected to a plurality of input ports of the port multiplexing logic module; a plurality of output ports of the port multiplexing logic module are connected to the plurality of general-purpose output ports; and the controller is respectively connected to the port multiplexing logic module and the port multiplexing logic module.

In the present embodiment, granularity is used to describe an I/O grouping, that is, the number of I/Os included in each group. The size of the granularity directly influences the degree of freedom of I/O allocation in scan test and the logical increment in the I/O reuse logic module. The minimum granularity can be set to 1.

Further, the smaller the granularity, the higher the degree of freedom of I/O allocation, but moreover, more scan I/O reuse logic need to be introduced; the larger the granularity, the scan I/O reuse logic will be effectively simplified, but the corresponding degree of freedom of scan I/O allocation in the scan test will be limited. Therefore, the granularity should be reasonably configured in the chip design phase, so as to achieve a balance between the degree of freedom of I/O allocation and the number of I/O reuse logics.

In the present embodiment, the grouping of logic units in each port or module in the chip is based on granularity In the present embodiment, the scan test logic module is configured to test embedded deterministic testing (EDT) channel chains conductively connected to the general-purpose input ports and the general-purpose output ports.

Specifically, an EDT channel chain is obtained by compressing a scan chain, and is a basic unit of embedded deterministic testing (EDT).

In the present embodiment, the controller is configured to send control instructions to the port multiplexing logic module and the port multiplexing logic module respectively.

In the present embodiment, the port multiplexing logic module is configured to conductively connect, according to the control instruction, the plurality of general-purpose input ports and some input ports of the scan test logic module by taking the I/O group as a unit, wherein the number of the plurality of general-purpose input ports is less than the number of the plurality of input ports of the scan test logic module.

In the present embodiment, the port multiplexing logic module is configured to conductively connect, according to the control instruction, some output ports of the scan test logic module and the plurality of general-purpose output ports by taking the I/O group as a unit, wherein the number of the plurality of general-purpose output ports is less than the number of the plurality of output ports of the scan test logic module.

Further, the port multiplexing logic module is configured to implement time division multiplexing of the general-purpose input ports, and the port multiplexing logic module is configured to implement time division multiplexing of the general-purpose output ports.

Specifically, the number of the general-purpose output/output ports is less than the number of input/output ports of the scan test logic module; the controller instructs the port multiplexing logic module and the port multiplexing logic module to enable the general-purpose output/output ports to be conductively connected to different input/output ports in the scan test logic module at different time, i.e., achieving time-division multiplexing of the general-purpose output/output ports, thereby guaranteeing the test effect on the scan test logic module in the case of limited I/O resources.

In some embodiments, the controller 600 may be a test access port (TAP) controller or other devices that may output control signals and control multiplexers/demultiplexers, which is not limited in the present disclosure.

through the embodiments of the present disclosure, dynamic adjustment of I/O resources is realized in a testing phase, so that I/O allocation is not limited by a chip design phase, even the grouping of test modules can be dynamically adjusted in different test modes according to the practical situation of the modules to be tested, thereby effectively reducing the testing time of a chip, and solving the problems of unreasonable I/O allocation and long test time of large-scale complex chips in the related art.

In some embodiments, the preset granularity is N, and each I/O group includes N general-purpose input ports and N general-purpose output ports, N being a positive integer.

In some embodiments, the scan test logic module includes a plurality of scan test modules, wherein each of the scan test modules includes at least one EDT channel chain, an input port of each of the EDT channel chains is an input port of the scan test logic module, and an output port of each of the EDT channel chains is an output port of the scan test logic module.

In some embodiments, the scan test logic module is configured to respectively test each test group of the plurality of test groups at different time, wherein each test group includes at least one EDT channel chain group, each EDT channel chain group includes N EDT channel chains, and the plurality of test groups are allocated according to attribute parameters of the plurality of scan test modules.

Further, the number of ports in each I/O group and the number of EDT channel chains in each EDT channel chain group are the same as the preset granularity. When one port in the I/O group is conductively connected to one EDT channel chain in the EDT channel chain group, the other ports in the I/O group are respectively conductively connected to the other EDT channel chains in the EDT channel chain group.

In the present embodiment, the number of general-purpose input/output ports is less than the number of EDT channel chains to be tested; and the conduction between the general-purpose input/output ports and the EDT channel chains can be dynamically adjusted through the configuration controller, enabling data transmission between the I/Os and the EDT channel chains.

In some embodiments, the attribute parameters of the scan test module may include, but are not limited to, any one or combination of the following parameters: the number of EDT channels, cross-talk paths between scan test modules, a test mode, the number of test vectors (patterns), and power consumption. The attribute parameters may also include any other parameters capable of affecting the test process or test result.

In some embodiments, the port multiplexing logic module and the port multiplexing logic module may be implemented by multiplexers or demultiplexers. Technicians can also implement time-division multiplexing of the I/O input/output ports through selectors or other logic operation modules, which is not limited in the present disclosure.

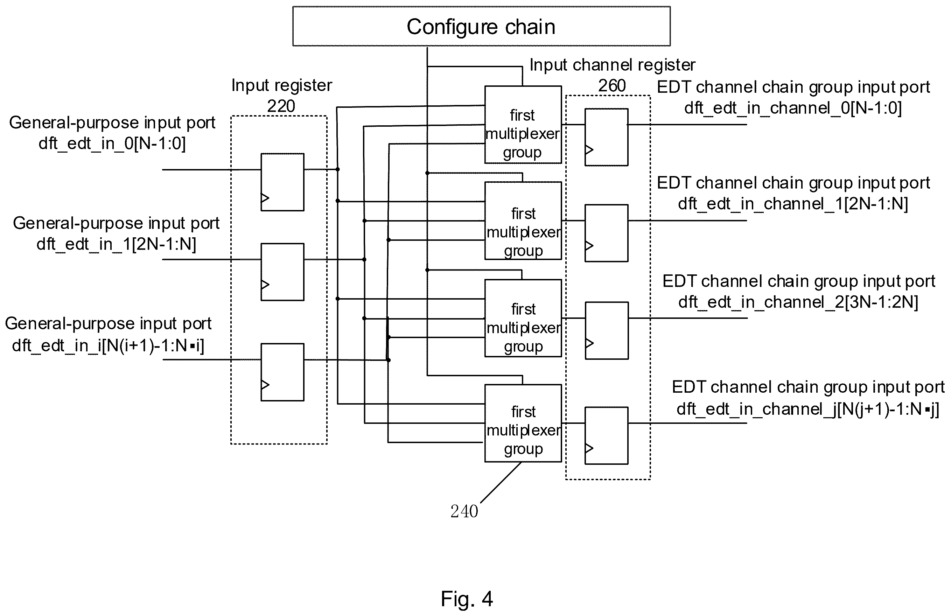

Fig. 4 is a schematic circuit structure diagram (I) of a port multiplexing logic module according to an embodiment of the present disclosure. As shown in Fig. 4, the port multiplexing logic module may include the following structure: a plurality of first multiplexer groups 240.

In the present embodiment, the number of the plurality of first multiplexer groups is the same as the number of the plurality of EDT channel chain groups.

In the present embodiment, each first multiplexer group includes a plurality of groups of input ports and a plurality of groups of output ports, and can gate one group of input ports and one group of output ports under the control of a control instruction.

In some embodiments, according to a preset granularity, the input ports of the port multiplexing logic module are divided into i+1 groups, including dft_edt_in_0 to dft_edt_in_i; each group of input ports is connected to a group of general-purpose input ports; the output ports of the port multiplexing logic module are divided into j+1 groups, including dft_edt_in_channel_0 to dft_edt_in_channel_j; and each group of output ports is connected to an EDT channel chain group. Correspondingly, the number of first multiplexer groups is j+1, i being less than j.

In some embodiments, the port multiplexing logic module may also include a plurality of input registers 220 and a plurality of input channel registers 260.

In some embodiments, the preset granularity is N, an input/output port group (I/O group) includes N input/output ports, each first multiplexer group includes N first multiplexers, and each EDT channel chain group includes N EDT channel chains.

Further, the circuit connections in Fig. 4 are implemented through buses, with each bus containing a group of N lines. The number of input registers 220 and the number of input channel registers 260 in Fig. 4 are omitted, and in fact, each line may be connected to a register.

In the present embodiment, an input (dft_edt_in) register is located on the input port side in the port multiplexing logic module; an input channel (dft_edt_in_channel) register is located on the output port side in the port multiplexing logic module; and the logic between the input register and the input channel register is the I/O multiplexing (scan io reuse) logic in the port multiplexing logic module.

In the present embodiment, each group of general-purpose input ports is respectively connected to the plurality of first multiplexer groups through the input register, and each first multiplexer group is connected to one EDT channel chain group through the input channel register, each first multiplexer in the first multiplexer group corresponding to one EDT channel chain in an EDT channel chain group.

In the present embodiment, the first multiplexer group is configured to gate one target I/O group among the plurality of I/O groups and a corresponding target EDT channel chain group according to the control instruction, wherein N general-purpose input ports in the target I/O group are conductively connected to input ports of N EDT channel chains in the target EDT channel chain group.

In some embodiments, when the granularity is N, each first multiplexer group includes N first multiplexers. Each first multiplexer has i+1 input ports and 1 output port, wherein the i+1 input ports are respectively connected to one general-purpose input port in the i+1 I/O groups, and the one output port is connected to an input port of one EDT channel chain. The first multiplexer may select one from i+1 general-purpose input ports as a target general-purpose input port to be conductively connected to a corresponding uniquely connected EDT channel chain, thereby implementing a test on the EDT channel chain.

In some embodiments, each group of N first multiplexers may be controlled by a control signal, thereby implementing gating of N paths. For example, the input port of the first of the first multiplexers in the first multiplexer group may be connected to a first port in each bus (or each group of general-purpose input ports), and one is selected from the plurality of first ports to be conductively connected to a first output port in an output port group of the first multiplexer group. Correspondingly, other first multiplexers in the first multiplexer group are sequentially connected to the corresponding ports in each bus (or each group of general-purpose input ports).

Further, the first of the first multiplexers in each first multiplexer group in Fig. 4 may be respectively connected to ports such as dft_edt_in_0[0], dft_edt_in_1[N] and dft_edt_in_i[N•i], and one port is selected therefrom to be connected to the first port in the corresponding output port group. The second one of the first multiplexers may be connected to ports such as dft_edt_in_0[1], dft_edt_in_1[N+1] and dft_edt_in_i[N•i+1], respectively, with other first multiplexers following a similar pattern.

In some embodiments, the logic of an I/O reuse logic module (scan io reuse) is controlled by a configure chain in a tap controller; and the gating logic of the first multiplexer or first multiplexer group can be controlled by the configure chain, thereby realizing dynamic I/O multiplexing allocation.

In the present embodiment, the configure chain in the tap controller is connected to a selection port dft_edt_in_sel of each of the multiplexers, so that only one path from dft_edt_in to dft_edt_in_channel in the multiplexer is gated, thereby implementing dynamic allocation and time division multiplexing of the scan io input port, and the bit width of the dft_edt_in_sel signal is related to the I/O granularity N.

In some embodiments, the control instruction includes a first serial instruction and a second serial instruction.

In some embodiments, the controller is configured to control, through the first serial instruction, a plurality of first multiplexer groups or a plurality of first demultiplexer groups in the port multiplexing logic module to gate the plurality of general-purpose input ports and some input ports of the scan test logic module.

In some embodiments, the controller is further configured to control, through the second serial instruction, a second plurality of multiplexer groups or a second plurality of demultiplexer groups in the port multiplexing logic module to gate some output ports of the scan test logic module and the plurality of general-purpose output ports.

In the embodiments of the present disclosure, by controlling the I/O reuse logic through the controller, time division multiplexing of the general-purpose input/output ports of a chip can be realized, and the grouping of I/Os can be adjusted during a test process, thereby effectively reducing EDT test time.

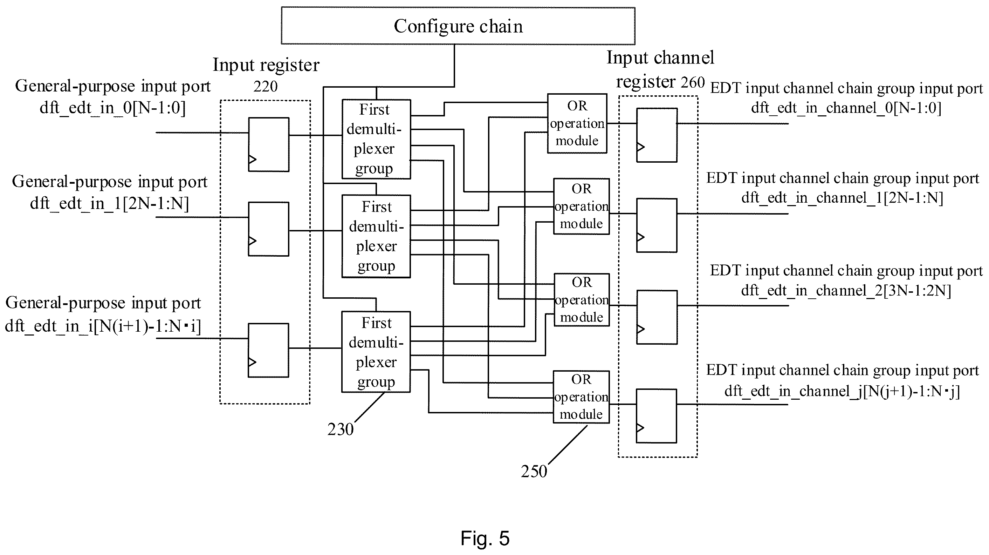

Fig. 5 is a schematic circuit structure diagram (II) of a port multiplexing logic module according to an embodiment of the present disclosure. As shown in Fig. 5, the port multiplexing logic module may include the following structure:
a plurality of first demultiplexer groups 230 and a plurality of OR operation modules 250.

In the present embodiment, the number of the plurality of first demultiplexer groups is the same as the number of the plurality of I/O groups.

In the present embodiment, each first demultiplexer group includes a group of input ports and a plurality of groups of output ports, and can gate one group of input ports and one group of output ports under the control of a control instruction.

In some embodiments, according to a preset granularity, the input ports of the port multiplexing logic module are divided into i+1 groups, including dft_edt_in_0 to dft_edt_in_i; each group of input ports is connected to a group of general-purpose input ports; the output ports of the port multiplexing logic module are divided into j+1 groups, including dft_edt_in_channel_0 to dft_edt_in_channel_j; and each group of output ports is connected to an EDT channel chain group; and a plurality of EDT channel chains are divided into j+1 EDT channel chain groups. Correspondingly, the number of the first demultiplexer groups is i+1, i being less than j.

In some embodiments, the port multiplexing logic module may also include a plurality of input registers 220 and a plurality of input channel registers 260.

In some embodiments, the preset granularity is N, an input/output port group (I/O group) includes N input/output ports, each first demultiplexer group includes N first demultiplexers, and each EDT channel chain group includes N EDT channel chains.

Further, the circuit connections in Fig. 5 are implemented through buses, with each bus containing a group of N lines. The number of input registers 220 and the number of input channel registers 260 in Fig. 5 are omitted, and in fact, each line may be connected to a register.

In the present embodiment, each group of general-purpose input ports is connected to one first demultiplexer group through the input register; each first demultiplexer group is respectively connected to the plurality of OR operation modules; and each OR operation module is connected to one EDT channel chain group through the input channel register.

In the present embodiment, the first demultiplexer group is configured to gate, according to the control instruction, one target EDT channel chain group among the plurality of EDT channel chain groups and a corresponding target I/O group, wherein N general-purpose input ports in the target I/O group are conductively connected to the input ports of N EDT channel chains in the target EDT channel chain group.

In some embodiments, when the granularity is N, each first demultiplexer group includes N first demultiplexers. Each first demultiplexer has one input port and j+1 output ports, wherein one input port is connected to one general-purpose input port in one I/O group, and each output port is respectively connected to a plurality of OR operation modules.

Further, each first demultiplexer selects a target output port from j+1 output ports under the control of a control instruction, conductively connects the input port to the target output port, and then transmits the signal to one target EDT channel chain in a corresponding EDT channel chain group through an OR operation module, thereby realizing the test on the target EDT channel chain.

In some embodiments, each group of N first demultiplexers may be controlled by a control signal, thereby implementing gating of N paths. For example, the input port of the first of the first demultiplexers in the first demultiplexer group may be connected to a first port in each bus (or each group of general-purpose input ports), and one is selected from the plurality of first ports to be conductively connected to a first output port in an output port group of the first demultiplexer group. Correspondingly, other first demultiplexers in the first demultiplexer group are sequentially connected to the corresponding ports in each bus (or each group of general-purpose input ports).

Further, the input port of the first of first demultiplexers in the first demultiplexer group in FIG. 5 is connected to dft_edt_in_0[0], and the output port may be respectively connected to ports such as dft_edt_in_channel_0[0], dft_edt_in_channel_1[N] and dft_edt_in_channel_j[N•j]; and select one port to be conductively connected. The other first demultiplexers can be analogized in sequence.

In some embodiments, each OR operation module is composed of a plurality of OR gates, and each OR operation module may have i+1 groups of input ports and a group of output ports, which are respectively connected to i+1 first demultiplexer groups and one EDT channel chain group. In combination with the control of the controller over the i+1 first demultiplexer groups, the OR operation module can transmit any input signal from the i+1 groups of input ports to the corresponding EDT channel chain group, wherein each OR operation module can only receive one group of conduction signals at a time.

In the present embodiment, the configure chain in the tap controller is connected to a selection port dft_edt_in_sel of each demultiplexer, so that only one path from dft_edt_in to dft_edt_in_channel in the demultiplexer is gated, thereby implementing dynamic allocation and time division multiplexing of the scan io input port. The bit width of the dft_edt_in_sel signal is related to the I/O granularity N.

In some embodiments, taking the structures of the port multiplexing logic modules in Figs. 4 and 5 as an example, the first multiplexer groups in Fig. 4 are close to the scan test logic module, and the number of the first multiplexer groups is equal to the number of the groups of the EDT channel chains, while the first multiplexer groups in Fig. 5 are close to the general-purpose input port, and the number of the first multiplexer groups is consistent with the number of the groups of the general-purpose input ports. Due to the smaller number of general-purpose input ports and the larger number of **EDT** channel chains inside the module, under otherwise identical conditions, the number of first demultiplexer groups in Fig. 5 is less than the number of first multiplexer groups in Fig. 4, and the internal conduction logic of the first demultiplexer groups is more complex.

Further, due to the exponential correlation between the bit of the gating end of the multiplexer groups/demultiplexer groups and the number of internal paths, selecting multiplexer groups/demultiplexer groups with more complex internal logic is beneficial for compressing the bit width of the selection port.

In some embodiments, in Figs. 4 and 5, the total numbers $N_{bit\,1}$ and $N_{bit\,2}$ of bits required by the selection port of the multiplexer groups/demultiplexer groups are:

$$N_{bit1} = (j+1)\log_2(i+1) \; ;$$

and

$$N_{\text{bit} 2} = (i+1)\log_2(j+1).$$

Since in general i< <j, thus $N_{\text{bit} 1} \gg N_{\text{bit} 2}$, i.e., the chain length of the configure chain in Fig. 5 will be shorter.

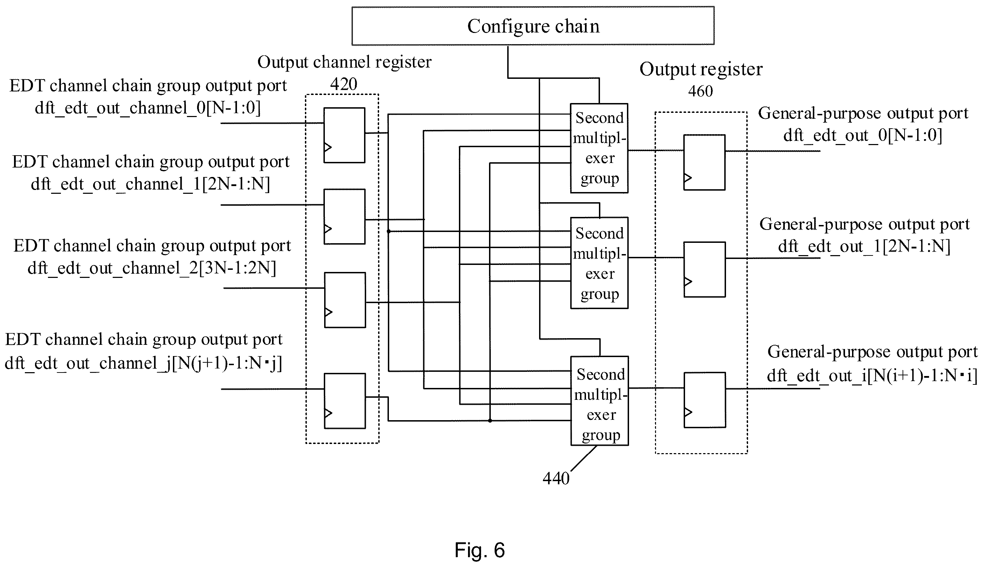

Fig. 6 is a schematic circuit structure diagram (III) of a port multiplexing logic module according to an embodiment of the present disclosure. As shown in Fig. 6, the port multiplexing logic module may include the following structure: a plurality of second multiplexer groups 440.

In the present embodiment, the number of second multiplexer groups is the same as the number of the plurality of EDT channel chain groups.

In the present embodiment, each second multiplexer group includes multiple groups of input ports and multiple groups of output ports, and can gate one group of input ports and one group of output ports under the control of a control instruction.

In some embodiments, when the granularity is N, the input ports of the port multiplexing logic module are divided into j+1 groups, including dft_edt_out_channel_0 to dft_edt_out_channel_j. Each group of input ports is connected to one group of EDT channel chains. The plurality of EDT channel chains are divided into j+1 EDT channel chain groups, and each EDT channel chain group includes N EDT channel chains. The output ports of the port multiplexing logic module are divided into i+1 groups, including dft_edt_out_0 to dft_edt_out_i. Each group of output ports is connected to one group of general-purpose output ports. The plurality of general-purpose output ports are divided into i+1 I/O groups, and each I/O group includes N general-purpose output ports. Correspondingly, the number of second multiplexer groups is i+1, i being less than j.

In some embodiments, the port multiplexing logic module may also include a plurality of output channel registers 420 and a plurality of output registers 460.

In some embodiments, the preset granularity is N, an input/output port group (I/O group) includes N input/output ports, each second demultiplexer group includes N second demultiplexers, and each EDT channel chain group includes N EDT channel chains.

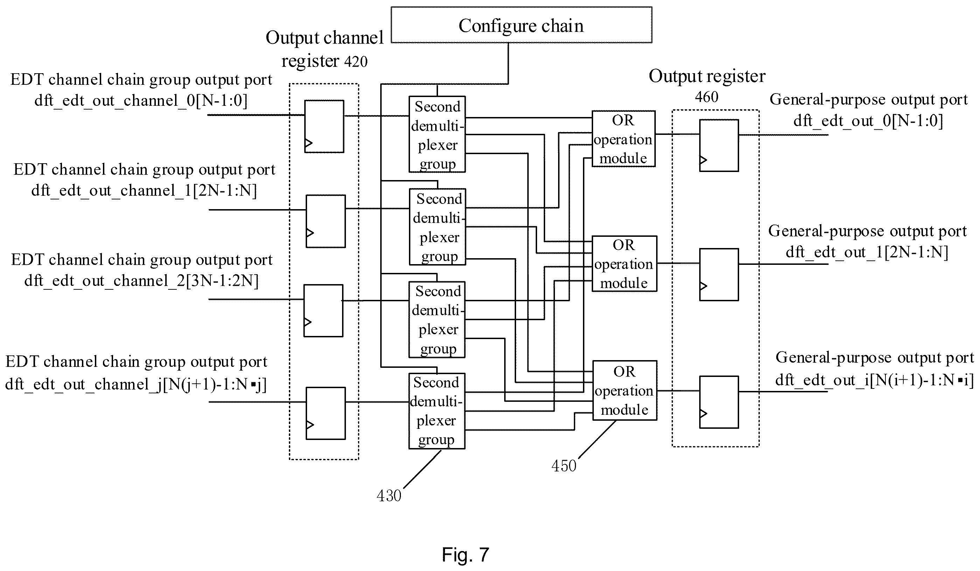

Further, the circuit connections in Fig. 7 are implemented through buses, with each bus containing a group of N lines.

In the present embodiment, each of the EDT channel chain groups is respectively connected to the plurality of second multiplexer groups through the output channel register; and each of the second multiplexer groups is connected to a group of general-purpose output ports through the output register.

In the present embodiment, the second multiplexer group is configured to gate, according to the control instruction, one target EDT channel chain group among the plurality of EDT channel chain groups and a corresponding target I/O group, wherein the output ports of N EDT channel chains in the target EDT channel chain group are conductively connected to N general-purpose output ports in the target I/O group.

In some embodiments, each second multiplexer group includes N second multiplexers. Each second multiplexer has j+1 input ports and 1 output port, wherein the j+1 input ports are respectively connected to one EDT channel chain in the j+1 EDT channel chain groups, and one output port is connected to one general-purpose output port. The second multiplexer may select one from j+1 EDT channel chains as a target EDT channel chain to be conductively connected to a corresponding unique output port, thereby obtaining a test result of the target EDT channel chain.

In some embodiments, the logic of an I/O reuse logic module (scan io reuse) is controlled by a configure chain in a tap controller. The gating logic of the second multiplexer or second multiplexer group can be controlled by the configure chain, thereby realizing dynamic I/O multiplexing allocation.

In the present embodiment, the configure chain in the tap controller is connected to a selection port dft_edt_out_sel of each multiplexer, so that only one path from dft_edt_out_channel to dft_edt_out in the multiplexer is gated, thereby implementing dynamic allocation and time division multiplexing of the scan io input port, and the bit width of the dft_edt_out_sel signal is related to the I/O granularity N.

Fig. 7 is a schematic circuit structure diagram (IV) of a port multiplexing logic module according to an embodiment of the present disclosure. As shown in Fig. 7, the port multiplexing logic module may include the following structure: a plurality of second demultiplexer groups 430 and a plurality of OR operation modules 450.

In the present embodiment, the number of second demultiplexer groups is the same as the number of the plurality of EDT channel chain groups.

In the present embodiment, each second demultiplexer group includes a group of input ports and a plurality of groups of output ports, and can gate one group of input ports and one group of output ports under the control of a control instruction.

In some embodiments, according to a preset granularity, the input ports of the port multiplexing logic module are divided into j+1 groups, including dft_edt_out_channel_0 to dft_edt_out_channel_j; each group of input ports are connected to a group of EDT channel chains; a plurality of EDT channel chains are divided into j+1 EDT channel chain groups; the output ports of the port multiplexing logic module are divided into i+1 groups, including dft_edt_out_0 to dft_edt_out_i; each group of output ports is connected to a group of general-purpose output ports; and the plurality of general-purpose output ports are divided into i+1 I/O groups. Correspondingly, the number of the second demultiplexer groups is j+1, i being less than j.

In some embodiments, the port multiplexing logic module may further include a plurality of output channel registers 420 and a plurality of output registers 460.

In the present embodiment, each EDT channel chain group is connected to one of the second demultiplexer groups through the output channel register; each of the plurality of second demultiplexer groups is respectively connected to a plurality of OR operation modules; and each of the OR operation modules is connected to one group of general-purpose output ports through the output register.

In the present embodiment, the second demultiplexer group is configured to gate one target I/O group among the plurality of I/O groups and a corresponding target EDT channel chain group according to the control instruction, wherein the output ports of N EDT channel chains in the target EDT channel chain group are conductively connected to N general-purpose output ports in the target I/O group.

In some embodiments, when the granularity is N, each second demultiplexer group includes N second multiplexers. Each second demultiplexer has one input port and i+1 output ports, wherein one input port is connected to one EDT channel chain, and each output port is respectively connected to a plurality of OR operation modules.

Further, each second demultiplexer selects a target output port from i+1 output ports under the control of a control instruction, conductively connects the input port to the target output port, and then transmits a signal of the target output port to a uniquely connected general-purpose output port through an OR operation module, so as to obtain a test result of the EDT channel chain.

In some embodiments, the logic of the I/O reuse logic (scan io reuse) module is controlled by the configure chain in the tap controller, and the gating logic of the second demultiplexers or the second demultiplexer groups can be controlled by the configure chain, thereby realizing dynamic I/O multiplexing allocation.

In the present embodiment, the configure chain in the tap controller is connected to a selection port dft_edt_out_sel of each demultiplexer, so that only one path from dft_edt_out_channel to dft_edt_out in the demultiplexer is gated, thereby implementing dynamic allocation and time division multiplexing of the scan io input port, and the bit width of the dft_edt_out_sel signal is related to the I/O granularity N.

In some embodiments, when the granularity is 1, the number of general-purpose input ports is i+1, and the number of EDT channel chains is j+1. Without considering the selection port, the number of standard units $N_{cell}$ required by the I/O reuse logic can be expressed as: $N_{cell} = (2(i + 1) - 1)(j + 1)$ .

In some embodiments, when the granularity is N, it is assumed that the number of general-purpose input ports is N(i+1) and the number of EDT channel chains is N(j+1), in this case, the number of I/O groups remains unchanged, the number of EDT channel chain groups remains unchanged, and correspondingly, the number of standard units $N_{cell}$ remains unchanged. With the same internal logic complexity, more I/O resources may be allocated in the embodiments of the present disclosure.

In some embodiments, when the granularity is N, assuming that the number of general-purpose input ports is i+1 and the number of EDT channel chains is j+1, then the number of corresponding I/O groups is (i+1)/N and the number of EDT channel chain groups is (j+1)/N, and in this case, the number of standard units $N_{cell}$ required by the I/O reuse logic module is:

$$N_{cell} = (2\frac{(i+1)}{N} - 1)\frac{(j+1)}{N} .$$

That is, the number of standard cells in the I/O reuse logic module will decrease in a relationship similar to the square of granularity $N^2$.

In some embodiments, it can be derived that the number of standard units $N_{cell}$ required by the I/O reuse logic module in Fig. 5 is:

$$N_{cell} = (2\frac{(i+1)}{N} - 1)\frac{(j+1)}{N} .$$

Further, Figs. 6 and 7 describe the transmission process from the EDT channel chain output port to the general-purpose output port. Similar to the input port transmission logic, the output signal is connected to the general-purpose output port through an output channel register, an I/O reuse logic module, and an output register. By configuring the configuration chain, which is used to control the selection port dft_edt_out_sel of the I/O reuse logic module, in the tap controller, a specific I/O reuse logic can be dynamically gated, thereby achieving dynamic allocation and time-division multiplexing of the general-purpose output ports.

In an exemplary embodiment, any combination of the I/O reuse logic modules in the described embodiments may be performed to obtain a complete port multiplexing logic module.

The port multiplexing logic module in the embodiments of the present disclosure is a dynamic scan io re-allocation technology proposed for the scan test mode, featuring high-freedom grouping capability, which can effectively address the key issue where I/O allocation is fixed and cannot be reallocated in the related art. Through the embodiment of the present disclosure, by using the scan io reuse logic, the I/O resources can be reallocated according to the optimal module grouping at any stage of chip design, even after chip tape-out. The entire process of scan io reallocation shows a high degree of flexibility and configurability, and plays an important role in chip design and testing.

In some embodiments, the scan test logic module includes a plurality of scan test modules, and the plurality of scan test modules may be divided into a plurality of test groups according to the attribute parameters of the plurality of scan test modules. Different test groups may be tested at different time by the scan test logic module.

Further, the attribute parameters include, but are not limited to, any one or a combination of the following parameters: the number of EDT channels, cross-talk paths between the scan test modules, test modes, the number of test vectors (patterns), and power consumption. The attribute parameters can be extended and selected according to the grouping strategy of the test modules. For example, the number of test vectors (patterns) is selected as the grouping basis in the shortest test time grouping strategy, and the power consumption is selected as the grouping basis in the optimal power consumption grouping strategy.

In an exemplary embodiment, grouping with a high degree of freedom can be realized through port multiplexing logic modules, thereby achieving the shortest test time grouping strategy and saving test costs.

In the present embodiment, in the chip scan test process, all modules are grouped and tested. The optimal grouping strategy is to ensure that the number of test vectors (patterns) of the test modules within each test group is similar, i.e., the test time for each test module is close to each other. This avoids situations where only one test module is tested at a period of time, thereby preventing wasted testing time.

In the present embodiment, it is assumed that eight test modules need to be tested, each test module has 4 EDT channels, the number of chip I/O resources is 16, and 4 test modules can be supported for testing at the same time, so the test needs to be divided into two groups.

Further, Table 1 is an example of the number of the patterns of eight test modules under different test modes, and as shown in Table 1, optimal grouping strategy can be determined in different test modes. For example, in a stuck-at mode, modules 0, 1, 2 and 3 are divided into one group, and modules 4, 5, 6 and 7 are divided into another group; in a transition mode, modules 0, 2, 3 and 4 are divided into one group, and modules 1, 5, 6 and 7 are divided into another group.

Table 1:

| Module number | 0 | 1 | 2 | 3 | 4 | 5 | 6 | 7 |
|---|---|---|---|---|---|---|---|---|
| The number of stuck-at patterns | 10k | 11k | 11.5k | 9k | 18k | 21k | 19k | 20k |
| The number of transition patterns | 30k | 68k | 35k | 28k | 40k | 70k | 65k | 66k |
| The number of EDT channels | 4 | 4 | 4 | 4 | 4 | 4 | 4 | 4 |

In the embodiments of the present disclosure, dynamic re-allocation of I/O resources can be achieved through the port multiplexing logic module, thereby enabling different groupings of test modules under different test modes. Through the embodiments of the present disclosure, the actual test time can also be effectively reduced, and the test efficiency can be improved.

In another exemplary embodiment, the port multiplexing logic module can realize grouping with a high degree of freedom, thereby realizing a grouping strategy with optimal power consumption.

In the present embodiment, the optimal power consumption grouping strategy during the testing process refers to avoiding aggregation between various test modules, leads to voltage drop (IR drop) caused by chip heating, thereby resulting in overkill during the testing.

In the present embodiment, during grouping, it is required to ensure an average distribution of power consumption of the test groups as far as possible, so as to avoid excessively high power consumption of a certain group.

In the present embodiment, it is assumed that eight test modules need to be tested, the number of EDT channels of each test module is four, the number of chip I/O resources is 16, and four test modules can be simultaneously supported for testing, and therefore the test needs to be divided into two groups.

Further, Table 2 is an example of power consumption and physical position distribution of eight test modules. As shown in Table 2, according to the optimal power consumption grouping strategy, the test groups should be adjusted to modules 0, 2, 5, and 7 as one group, while modules 1, 3, 4, and 6 as another group.

Table 2:

| Module 0 (2W) | Module1 (1W) | Module2 (2W) | Module3 (2W) |
|---|---|---|---|
| Module4 (2W) | Module5 (1W) | Module6 (1W) | Module7 (1W) |

In the embodiments of the present disclosure, dynamic I/O resource reallocation may be implemented through the port multiplexing logic module, thereby dynamically readjusting the test module grouping strategy according to the power consumption. through the embodiments of the present disclosure, a grouping strategy can be dynamically adjusted according to the actual power consumption distribution, thereby testing the true chip quality and improving the yield.

In another exemplary embodiment, a port multiplexing logic module may be used to implement grouping with a high degree of freedom, thereby achieving full coverage testing of the cross-talk paths between test modules.

In the present embodiment, in a scan extest mode, assuming the crosstalk relationships between the test modules are as follows: modules 0, 1, 2, and 3 each have crosstalk with every other module pairwise; modules 4, 5, 6 and 7 each have crosstalk with every other module pairwise; there is cross-talk between modules 0 and 4; there is cross-talk between modules 1 and 5; there is cross-talk between modules 2 and 6; and there is cross-talk between modules 3 and 7. In order to fully cover all cross-talk paths, the scan extest grouping should include the following four groups: modules 0, 1, 2 and 3 as the first group; modules 4, 5, 6 and 7 as a second group; modules 0, 4, 1 and 5 as a third group; modules 2, 6, 3 and 7 as a fourth group.

In the embodiments of the present disclosure, dynamic re-allocation of I/O resources can be achieved, satisfying the requirements of various module groupings and thereby enabling full cross-coverage testing of cross-talk paths between test modules. Through the embodiments of the present disclosure, all the test paths can be covered, thereby improving the accuracy of a test, and being beneficial to chip screening.

The embodiments of the present disclosure further provide an electronic device, including the chip of any one of the above embodiments.

For specific examples in the present embodiment, reference can be made to the examples described in the described embodiments and exemplary embodiments, and thus they will not be repeated again in the present embodiment.

The content above only relates to exemplary embodiments of the present disclosure, and is not intended to limit the present disclosure. For a person skilled in the art, the present disclosure may have various modifications and changes. Any modifications, equivalent replacements, improvements, etc. made within the principle of the present disclosure shall all fall within the scope of protection of the present disclosure.

**Claims**

1. A chip, comprising a plurality of chip ports, a port multiplexing logic module and a scan test logic module, wherein

the port multiplexing logic module has a plurality of groups of first ports and a plurality of groups of second ports, and the plurality of chip ports are divided into a plurality of groups according to a preset granularity;
each group of chip ports is connected to at least one group of the plurality of groups of first ports and the plurality of groups of second ports of the port multiplexing logic module; and the plurality of groups of first ports or the plurality of groups of second ports of the port multiplexing logic module are connected to the scan test logic module; and the port multiplexing logic module is configured to control path gating between the chip ports and the scan test logic module at a preset granularity according to a control instruction.

2. The chip according to claim 1, wherein

the plurality of chip ports are divided into i+1 groups, and the number of port groups of the scan test logic module is j+1, wherein i being less than j, and i and j being positive integers;
in a case where the chip ports are chip input ports, where the plurality of groups of first ports of the port multiplexing logic module are a plurality of groups of input ports, and where the plurality of groups of second ports of the port multiplexing logic module are a plurality of groups of output ports, each group of chip ports is connected to at least one group of the plurality of groups of first ports of the port multiplexing logic module, the plurality of groups of second ports of the port multiplexing logic module are connected to the scan test logic module, the number of input port groups of the port multiplexing logic module is i+1, and the number of output port groups of the port multiplexing logic module is j+1.

3. The chip according to claim 2, wherein

the port multiplexing logic module comprises j+1 first multiplexer groups, wherein each of the first multiplexer groups is connected to i+1 input port groups of the port multiplexing logic module, and each of the first multiplexer groups is connected to one output port group of the port multiplexing logic module;
first multiplexer group is configured to gate one target input port group among the i+1 input port groups and a corresponding target output port group according to the control instruction.

4. The chip according to claim 3, wherein
in a case where the preset granularity is N, each of the input port groups comprises N input ports, each of the output port groups comprises N output ports, and each of the first multiplexer groups comprises N first multiplexers.

5. The chip according to claim 2, wherein

the port multiplexing logic module comprises i+1 first demultiplexer groups and j+1 OR operation modules, wherein each of the first demultiplexer groups is connected to one input port group of the port multiplexing logic module, each of the first demultiplexer groups is connected to the j+1 OR operation modules, and each of the OR operation modules is connected to one output port group of the port multiplexing logic module;
first demultiplexer group is configured to gate one target output port group among j+1 output port groups and a corresponding target input port group according to the control instruction.

6. The chip according to claim 5, wherein
in a case where the preset granularity is N, each of the input port groups comprises N input ports, each of the output port groups comprises N output ports, and each of the first demultiplexer groups comprises N first demultiplexers.

7. The chip according to claim 1, wherein

the plurality of chip ports are divided into i+1 groups, and the number of port groups of the scan test logic module is j+1, wherein i being less than j, and i and j being positive integers;
in a case where the chip ports are chip output ports, where the plurality of groups of second ports of the port multiplexing logic module are a plurality of groups of output ports, and where the plurality of groups of first ports of the port multiplexing logic module are a plurality of groups of input ports, each group of chip ports is connected to at least one group of the plurality of groups of second ports of the port multiplexing logic module, the plurality of groups of first ports of the port multiplexing logic module are connected to the scan test logic module, the number of input port groups of the port multiplexing logic module is j+1, and the number of output port groups of the port multiplexing logic module is i+1.

8. The chip according to claim 7, wherein

the port multiplexing logic module comprises i+1 second multiplexer groups, wherein each of the second multiplexer groups is connected to j+1 input port groups of the port multiplexing logic module, and each of the second multiplexer groups is connected to one output port group of the port multiplexing logic module;
second multiplexer group is configured to gate one target input port group among the j+1 input port groups and a corresponding target output port group according to the control instruction.

9. The chip according to claim 8, wherein
in a case where the preset granularity is N, each of the input port groups comprises N input ports, each of the output port groups comprises N output ports, and each of the second multiplexer groups comprises N second multiplexers.

10. The chip according to claim 7, wherein

the port multiplexing logic module comprises j+1 second demultiplexer groups and i+1 OR operation modules, wherein each of the second demultiplexer groups is connected to one input port group of the port multiplexing logic module, each of the second demultiplexer groups is connected to the i+1 OR operation modules, and each of the OR operation modules is connected to one output port group of the port multiplexing logic module;
second demultiplexer group is configured to gate one target output port group among i+1 output port groups and a corresponding target input port group according to the control instruction.

**11.** The chip according to claim 10, wherein
in a case where the preset granularity is N, each of the input port groups comprises N input ports, each of the output port groups comprises N output ports, and each of the second demultiplexer groups comprises N second demultiplexers.

**12.** The chip according to any one of claims 1 to 11, wherein

the scan test logic module comprises a plurality of embedded deterministic testing, EDT, channel chains, wherein the plurality of EDT channel chains are divided into a plurality of groups according to the preset granularity; and the scan test logic module is configured to test a plurality of groups of EDT channel chains conductively connected to the chip ports.

**13.** The chip according to claim 12, wherein

the scan test logic module comprises a plurality of scan test modules, wherein each of the scan test modules comprises at least one EDT channel chain;
the scan test logic module is configured to respectively test each test group of a plurality of test groups at different time, wherein each test group comprises at least one EDT channel chain group, and the plurality of test groups are allocated according to attribute parameters of the plurality of scan test modules.

**14.** The chip according to claim 13, wherein the chip further comprises:
a controller configured to send the control instruction to the port multiplexing logic module.

**15.** An electronic device, comprising the chip according to any one of claims 1 to 14.

chip port 12

chip port 12

......

chip port 12

port multipl-exing logic module 14

scan test logic module 16

Fig. 1

controller 24

port multiplex-ing logic module 26

scan test logic module 28

port multiplex-ing logic module 26

chip port 22

chip port 22

Fig. 2

100 600 500

general-purpose input port

controller

general-purpose output port

input port multipl-exing logic module

scan test logic module

output port multipl-exing logic module

200 300 400

Fig. 3

Fig. 4

Fig. 5

Fig. 6

General-purpose output port dft_edt_out_0[N-1:0]

General-purpose output port dft_edt_out_1[2N-1:N]

General-purpose output port dft_edt_out_i[N(i+1)-1:N·i]

Output register 460

Configure chain

OR operation module

450

Second demultiplexer group

430

Output channel register 420

EDT channel chain group output port dft_edt_out_channel_0[N-1:0]

EDT channel chain group output port dft_edt_out_channel_1[2N-1:N]

EDT channel chain group output port dft_edt_out_channel_2[3N-1:2N]

EDT channel chain group output port dft_edt_out_channel_j[N(j+1)-1:N·j]

Fig. 7

# EP 4 726 403 A1

## INTERNATIONAL SEARCH REPORT

International application No.

**PCT/CN2024/088056**

### A. CLASSIFICATION OF SUBJECT MATTER

G01R31/317(2006.01)i

According to International Patent Classification (IPC) or to both national classification and IPC

### B. FIELDS SEARCHED

Minimum documentation searched (classification system followed by classification symbols)

IPC: G01R

Documentation searched other than minimum documentation to the extent that such documents are included in the fields searched

Electronic data base consulted during the international search (name of data base and, where practicable, search terms used)

CNTXT, ENTXTC, CNKI: 深圳市中兴微电子技术有限公司, 彭敏强, 程琪, 陈曦午, 黄小斌, 芯片, 端口, 输入, 输出, 复用, 逻辑, 扫描, 测试, 粒度, 分组, 分类, chip, test, input, output, scan, chain, logic, multiplex, port, group+, classif+, granularity

### C. DOCUMENTS CONSIDERED TO BE RELEVANT

| Category* | Citation of document, with indication, where appropriate, of the relevant passages | Relevant to claim No. |
|---|---|---|
| Y | WO 2023272439 A1 (HUAWEI TECHNOLOGIES CO., LTD.) 05 January 2023 (2023-01-05) description, paragraphs 7 and 59, and figure 11 | 1, 12-15 |
| Y | CN 108737829 A (INTEL CORP.) 02 November 2018 (2018-11-02) description, paragraph 39 | 1, 12-15 |
| A | CN 102341719 A (ALCATEL LUCENT) 01 February 2012 (2012-02-01) entire document | 1-15 |
| A | CN 113868173 A (INTEL CORP.) 31 December 2021 (2021-12-31) entire document | 1-15 |
| A | CN 113986813 A (SUZHOU INSPUR INTELLIGENT TECHNOLOGY CO., LTD.) 28 January 2022 (2022-01-28) entire document | 1-15 |
| A | US 2011119646 A1 (MURRAY, David et al.) 19 May 2011 (2011-05-19) entire document | 1-15 |

☑ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **06 June 2024** | **14 June 2024** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

International application No.

**PCT/CN2024/088056**

### C. DOCUMENTS CONSIDERED TO BE RELEVANT

| Category* | Citation of document, with indication, where appropriate, of the relevant passages | Relevant to claim No. |
|---|---|---|
| A | US 2021156911 A1 (INTERNATIONAL BUSINESS MACHINES CORP.) 27 May 2021 (2021-05-27)<br>entire document | 1-15 |
| A | US 2022308110 A1 (SIEMENS INDUSTRY SOFTWARE INC.) 29 September 2022 (2022-09-29)<br>entire document | 1-15 |
| A | US 2023138651 A1 (INFINEON TECHNOLOGIES A.G.) 04 May 2023 (2023-05-04)<br>entire document | 1-15 |

Form PCT/ISA/210 (second sheet) (July 2022)

**INTERNATIONAL SEARCH REPORT**
Information on patent family members

| International application No. |
| --- |
| **PCT/CN2024/088056** |

| Patent document cited in search report | | | Publication date (day/month/year) | Patent family member(s) | | | Publication date (day/month/year) |
| --- | --- | --- | --- | --- | --- | --- | --- |
| WO | 2023272439 | A1 | 05 January 2023 | CN | 117396764 | A | 12 January 2024 |
| CN | 108737829 | A | 02 November 2018 | EP | 3396958 | A1 | 31 October 2018 |
| | | | | US | 2018308257 | A1 | 25 October 2018 |
| | | | | US | 10424082 | B2 | 24 September 2019 |
| | | | | US | 2019228544 | A1 | 25 July 2019 |
| | | | | US | 10872441 | B2 | 22 December 2020 |
| CN | 102341719 | A | 01 February 2012 | KR | 20120023601 | A | 13 March 2012 |
| | | | | KR | 101329465 | B1 | 13 November 2013 |
| | | | | EP | 2404182 | A1 | 11 January 2012 |
| | | | | EP | 2404182 | B1 | 21 May 2014 |
| | | | | JP | 2014067436 | A | 17 April 2014 |
| | | | | WO | 2010101995 | A1 | 10 September 2010 |
| | | | | EP | 2404183 | A1 | 11 January 2012 |
| | | | | EP | 2404183 | B1 | 13 August 2014 |
| | | | | WO | 2010101984 | A1 | 10 September 2010 |
| | | | | US | 2010229042 | A1 | 09 September 2010 |
| | | | | US | 8677198 | B2 | 18 March 2014 |
| | | | | KR | 20110122165 | A | 09 November 2011 |
| | | | | KR | 20130081717 | A | 17 July 2013 |
| | | | | KR | 101533170 | B1 | 02 July 2015 |
| | | | | JP | 2012519853 | A | 30 August 2012 |
| | | | | JP | 5683502 | B2 | 11 March 2015 |
| | | | | JP | 2012519854 | A | 30 August 2012 |
| | | | | JP | 5684739 | B2 | 18 March 2015 |
| | | | | EP | 2404184 | A1 | 11 January 2012 |
| | | | | EP | 2404184 | B1 | 02 October 2013 |
| | | | | WO | 2010102019 | A1 | 10 September 2010 |
| | | | | US | 2010229036 | A1 | 09 September 2010 |
| | | | | US | 8533545 | B2 | 10 September 2013 |
| | | | | KR | 20110124274 | A | 16 November 2011 |
| | | | | KR | 101489550 | B1 | 24 March 2015 |
| | | | | JP | 2012519912 | A | 30 August 2012 |
| | | | | JP | 5489249 | B2 | 14 May 2014 |
| | | | | KR | 20130100018 | A | 06 September 2013 |
| | | | | US | 2010229058 | A1 | 09 September 2010 |
| CN | 113868173 | A | 31 December 2021 | US | 2017255582 | A1 | 07 September 2017 |
| | | | | US | 10877915 | B2 | 29 December 2020 |
| | | | | TW | 201732620 | A | 16 September 2017 |
| | | | | TWI | 743078 | B | 21 October 2021 |
| | | | | US | 2021232522 | A1 | 29 July 2021 |
| | | | | US | 11321264 | B2 | 03 May 2022 |
| | | | | WO | 2017151267 | A1 | 08 September 2017 |
| | | | | DE | 112017001148 | T5 | 22 November 2018 |
| | | | | US | 2022334994 | A1 | 20 October 2022 |
| | | | | US | 11768791 | B2 | 26 September 2023 |
| CN | 113986813 | A | 28 January 2022 | None | | | |
| US | 2011119646 | A1 | 19 May 2011 | US | 8386980 | B2 | 26 February 2013 |
| US | 2021156911 | A1 | 27 May 2021 | US | 11079433 | B2 | 03 August 2021 |
| US | 2022308110 | A1 | 29 September 2022 | EP | 4025922 | A1 | 13 July 2022 |

Form PCT/ISA/210 (patent family annex) (July 2022)

## INTERNATIONAL SEARCH REPORT
### Information on patent family members

| International application No. |
| --- |
| **PCT/CN2024/088056** |

| Patent document cited in search report | | | Publication date (day/month/year) | Patent family member(s) | | | Publication date (day/month/year) |
| --- | --- | --- | --- | --- | --- | --- | --- |
| | | | | US | 11815555 | B2 | 14 November 2023 |
| | | | | WO | 2021045769 | A1 | 11 March 2021 |
| US | 2023138651 | A1 | 04 May 2023 | JP | 2023067828 | A | 16 May 2023 |
| | | | | DE | 102021128331 | B3 | 23 March 2023 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310804578